Europäisches Patentamt

European Patent Office

Office européen des brevets

(19)

(11) **EP 1 109 171 A1**

## (12) DEMANDE DE BREVET EUROPEEN

(43) Date de publication:
 **20.06.2001 Bulletin 2001/25**

(51) Int Cl.⁷: **G11C 27/02**

(21) Numéro de dépôt: **00403491.4**

(22) Date de dépôt: **12.12.2000**

| | |
|---|---|
| (84) Etats contractants désignés:<br>**AT BE CH CY DE DK ES FI FR GB GR IE IT LI LU MC NL PT SE TR**<br>Etats d'extension désignés:<br>**AL LT LV MK RO SI** | (72) Inventeur: **Ducourant, Thierry,**<br>**Thomson-CSF Prop. Intell.**<br>**94117 Arcueil Cedex (FR)** |
| (30) Priorité: **17.12.1999 FR 9915995** | (74) Mandataire: **Guérin, Michel et al**<br>**Thomson-CSF Propriété Intellectuelle,**<br>**13, Avenue du Président Salvador Allende**<br>**94117 Arcueil Cédex (FR)** |
| (71) Demandeur: **Trixell S.A.S.**<br>**38430 Moirans (FR)** | |

(54) **Circuit de lecture de charges protégé contre des surcharges provenant de charges de polarité non desirée**

(57)    La présente invention est un circuit de lecture de charges injectées à son entrée (E) comportant un transistor MOS de lecture (M1) dont le type conditionne la polarité des charges que le circuit de lecture est capable de lire sans se bloquer, et un condensateur d'intégration (C) monté entre une première électrode de la paire drain-source du transistor MOS de lecture (M1) et un potentiel de référence (VDR). L'entrée (E) du circuit se trouve au niveau de la seconde électrode de la paire drain-source du transistor MOS de lecture (M1). Les charges injectées doivent traverser le transistor MOS de lecture (M1) pour être intégrées par le condensateur

(C). Le transistor MOS de lecture (M1) est commandé par une tension de contrôle (V1) variant de manière sensiblement inversement proportionnelle par rapport à la tension (Ve) à l'entrée. Il comporte des moyens (A2) pour détecter, l'arrivée à l'entrée (E) de charges de polarité opposée à celles qu'il est capable de lire et des moyens (M2) pour imposer à la tension à l'entrée, après une telle détection, une valeur d'équilibre (VDRN) égale ou proche d'une valeur de base (Vb) qu'elle prend entre deux intégrations successives de charges de la polarité désirée, de manière à éviter un blocage prolongé du transistor MOS de lecture (M1) lors de l'arrivée de charges de polarité désirée.

FIG.3

## Description

La présente invention est relative aux circuits de lecture de charges destinés notamment à la lecture de charges captées par des capteurs d'image à l'état solide.

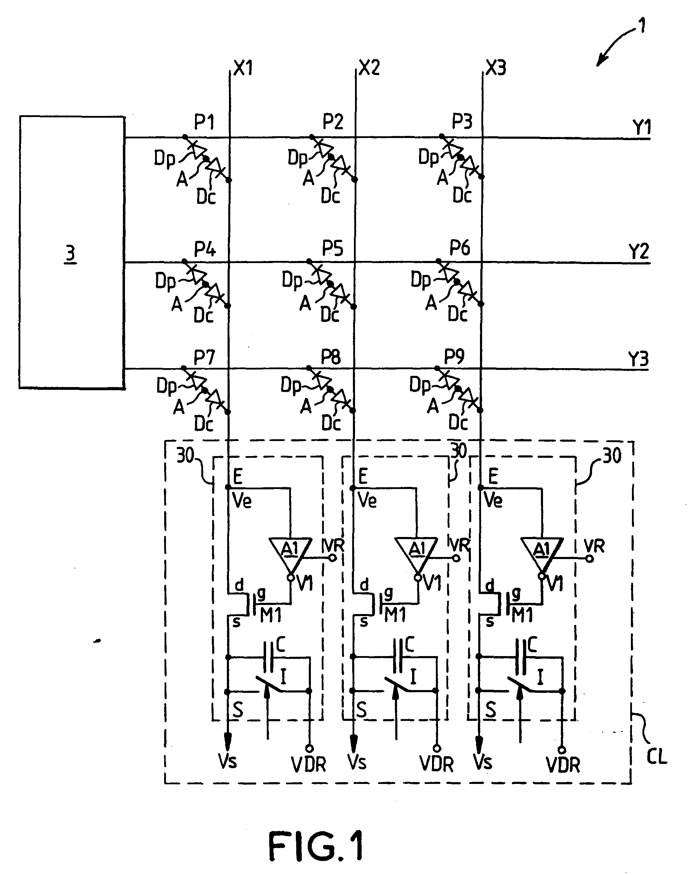

Ces circuits de lecture de charges sont de type intégrateurs de charges. De tels circuits de lecture 30 de type connu sont représentés sur la figure 1. Plus particulièrement sur la figure 1, on distingue un capteur d'image 1 avec une pluralité de points photosensibles P1 à P9 connectés chacun entre un conducteur de ligne Y1 à Y3 et un conducteur de colonne X1 à X3. Chaque point photosensible P1 à P9 est formé d'une diode photosensible Dp montée en série avec un élément à fonction d'interrupteur représenté sous la forme d'une diode de commutation Dc. On aurait pu utiliser un transistor comme élément à fonction d'interrupteur. Les conducteurs de ligne Y1 à Y3 sont reliés à au moins un dispositif d'adressage 3 tandis que les conducteurs de colonne X1 à X3 à un dispositif de lecture CL comportant autant de circuits de lecture 30 que de conducteurs de colonne X1 à X3. Ces circuits de lecture 30 sont capables, lors d'une opération d'intégration, de transformer des charges en tension, ces charges s'étant accumulées au point de jonction A entre la diode photosensible Dp et l'élément à fonction d'interrupteur Dc d'un point photosensible auxquels ils sont reliés. Cette accumulation a lieu lorsque les diodes photosensibles Dp sont dans un état réceptif et que les points photosensibles sont exposés à une information à capter.

La lecture de tous les points photosensibles reliés à un même conducteur de ligne Y1 à Y3 se fait en même temps, conducteur de ligne par conducteur de ligne. Les points photosensibles d'un même conducteur de colonne X1 à X3 sont lus chacun leur tour par le circuit de lecture 30 relié à ce conducteur de colonne.

On cherche à ce que la transformation se fasse avec une relation de proportionnalité la plus constante possible entre la quantité de charges accumulées et la tension délivrée par le circuit de lecture 30 de manière à ce que l'image délivrée par le dispositif de lecture CL soit la plus proche possible de l'image à détecter.

Chaque circuit de lecture 30 possède une entrée E formée par une des électrodes de la paire drain d, source s d'un transistor MOS de lecture M1. Cette entrée E est reliée à l'un des conducteurs de colonne X1 à X3 sur lequel circulent les charges accumulées. La sortie S du circuit de lecture 30 se fait du côté de l'autre électrode (source s ou drain d) du transistor MOS de lecture M1 qui est reliée à l'une des armatures d'un condensateur d'intégration C. L'autre armature reçoit une tension de référence VDR. Il y a transfert direct des charges injectées en entrée E du circuit de lecture 30 via le transistor MOS de lecture M1 et intégration par le condensateur C, si le transistor est conducteur. Le transfert des charges peut être accéléré par l'application d'une tension de contrôle V1 sur la grille g du transistor MOS de lecture M1. Cette tension de contrôle V1 est délivrée par un amplificateur inverseur d'accélération A1 dont l'entrée est reliée à l'entrée E du circuit de lecture 30. La tension V1 est telle que :

$$V1 = - GxVe$$

avec Ve tension à l'entrée E du circuit de lecture 30 et G gain en tension de l'amplificateur A1. Dans la pratique le gain G est élevé choisi par exemple entre 500 et 1000 de façon à réduire le bruit associé au transfert des charges entre l'entrée E et la sortie S. L'amplificateur inverseur A1 est alimenté par une tension d'alimentation VR négative (par exemple de l'ordre de -2, 75 Volts).

Il est prévu de plus, en parallèle avec le condensateur C un interrupteur I pour le réinitialiser lorsque toutes les charges provenant d'un point photosensible ont été intégrées et avant d'intégrer celles provenant d'un autre point photosensible.

Ce type de circuit de lecture 30 est unidirectionnel et c'est un inconvénient car il ne peut intégrer que des charges d'un unique type de polarité, c'est-à-dire soit des charges positives (trous), soit des charges négatives (électrons). Le type de polarité est conditionné par la nature du canal du transistor MOS de lecture M1.

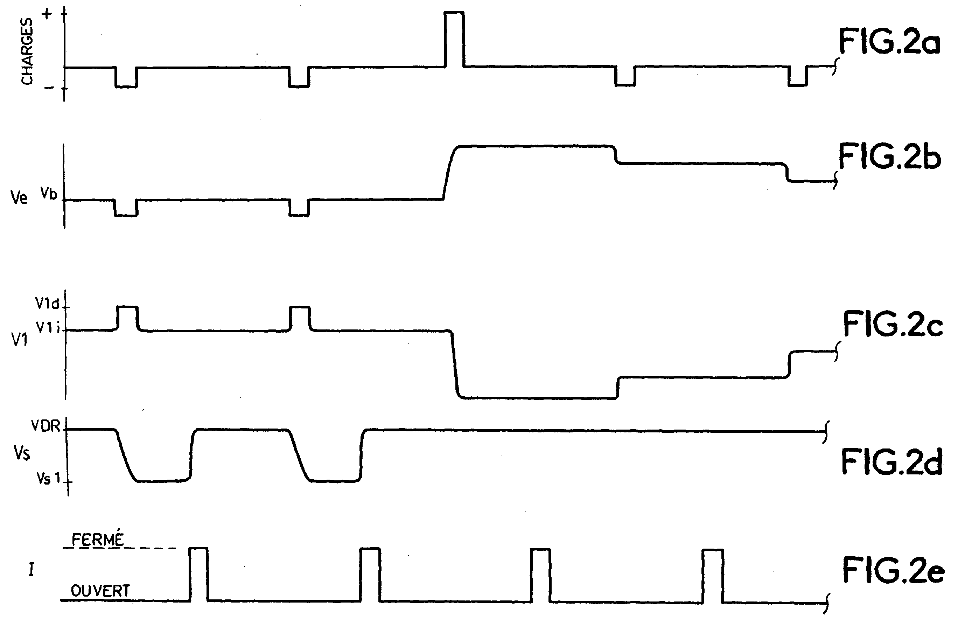

Si le transistor MOS M1 est à canal N, les charges injectées dans le transistor MOS M1 ne peuvent être que des électrons et la tension VDR est plus positive que la tension Ve. Si au lieu d'injecter des électrons, ce sont des trous qui sont injectés, la tension d'entrée Ve devient plus positive que la tension de référence VDR, et la tension de contrôle V1 vient alors bloquer le transistor MOS de lecture M1. Tant que le transistor MOS de lecture M1 est bloqué toutes les charges injectées en entrée E du circuit de lecture 30 ne peuvent être intégrées et les informations qu'elles transportent sont alors perdues. Les chronogrammes des figures 2a à 2e montrent les allures respectivement de la quantité de charges arrivant en entrée E d'un des circuits de lecture 30, de la tension Ve en entrée E du circuit, de la tension de contrôle V1 appliquée sur la grille g du transistor MOS de lecture M1, de la tension Vs en sortie S du circuit de lecture 30 et enfin de l'état de l'interrupteur I qui réinitialise le condensateur C. On suppose que dans l'exemple décrit, le transistor MOS M1 est à canal N et que le circuit de lecture est capable de lire des quantités de charges négatives ou électrons. S'il était à canal P, il serait capable de lire des trous et les signes des tensions et leurs sens de variation seraient inversés dans la description qui suit.

Lorsque des paquets d'électrons arrivent en entrée E du circuit de lecture, la tension Ve à l'entrée E du circuit 30 décroît brusquement à partir d'une valeur de base Vb, la tension de contrôle V1 elle se met à croître depuis une valeur initiale V1i jusqu'à une valeur V1d et le transistor MOS M1 se débloque. La valeur de base Vb est égale à somme de la tension d'alimentation VR de l'amplificateur d'accélération A1 et de la tension de seuil du transistor inclus dans l'amplificateur. Le détail de l'amplificateur A1 n'est pas donné.

Les charges peuvent être intégrées. La tension Vs à la sortie S, initialement portée à la valeur VDR se met à décroître jusqu'à atteindre la valeur Vs1 après intégration de toutes les charges reçues. Lorsque toutes les charges sont intégrées, la tension Ve à l'entrée revient à sa valeur de base Vb, la tension V1 à la sortie revient également à la valeur initiale V1 i et le transistor MOS de lecture M1 se bloque. La tension Vs conserve la valeur Vs1 atteinte tant que l'interrupteur I de remise à zéro reste en position ouverte, puis repasse à la valeur VDR de référence dès sa fermeture.

Lorsqu'un point photosensible est défectueux, ce qui correspond à au moins un de ses composants (diode photosensible Dp ou élément à fonction d'interrupteur Dc) hors service, un grand nombre de trous arrive en entrée E du circuit de lecture 30 auquel il est relié. Ce nombre est généralement beaucoup plus grand que celui des électrons qui arrivent d'un point photosensible en état de fonctionner même s'il a été exposé à un flux lumineux très intense. On qualifie cette arrivée de trous de suréblouissement inverse. La tension Ve à l'entrée augmente fortement, la tension V1 de contrôle qui suit, en les inversant et en les amplifiant, les variations de la tension Ve à l'entrée décroît brutalement et le transistor MOS M1 qui était bloqué reste bloqué, la tension Vs à la sortie S ne varie pas, elle reste à la valeur de référence VDR. La fermeture de l'interrupteur I de remise à zéro n'a aucune action sur la tension Vs à la sortie. Lorsqu'à nouveau des électrons arrivent en entrée E du circuit de lecture, la tension Ve à l'entrée décroît légèrement, la tension de contrôle V1 également mais cela ne suffit pas pour débloquer le transistor MOS de lecture M1. La tension Vs à la sortie ne varie pas et l'information dont sont porteurs les électrons arrivés entrée E est perdue. Il faut qu'à l'entrée du circuit de lecture, on récupère au moins autant d'électrons que de trous pour débloquer le transistor MOS de lecture M1. Cela se traduit sur l'image détectée par une portion de colonne qui reste noire, cette portion correspond à tous les points photosensibles de la colonne lus après celui qui est défectueux tant que le transistor MOS M1 n'est pas débloqué. Il n'est pas rare que la portion de colonne noire corresponde à plus d'une dizaine de points photosensibles. Ce défaut n'est pas tolérable.

De la même manière, si le transistor MOS de lecture M1 est de type canal P, les charges injectées à travers le transistor MOS M1 ne peuvent être que des trous et la valeur de référence VDR est plus négative que la tension Ve à l'entrée. Si au lieu d'injecter des trous, ce sont des électrons qui sont injectés, la tension Ve à l'entrée devient plus négative que la valeur de référence VDR, et la tension de contrôle V1 vient alors bloquer le transistor MOS M1. Tant que le transistor MOS M1 est bloqué plus aucunes charges ne peuvent être intégrées et les informations qu'elles transportent sont alors perdues.

Dans tous les cas, ce type de circuit de lecture 30 se bloque lorsqu'il est amené à fonctionner avec des charges de polarité opposée à celle pour laquelle il a été conçu.

La présente invention vise à limiter le blocage du circuit de lecture de charges à la lecture des charges provenant d'un point photosensible défectueux et permet de le rendre opérationnel pour la lecture du premier point photosensible non défectueux suivant. Un point photosensible défectueux ne perturbe pas la lecture ultérieure par le même circuit d'autres points photosensibles qui sont eux en état de fonctionner.

Pour y parvenir la présente invention propose un circuit de lecture de charges injectées à son entrée qui comporte un transistor MOS de lecture et un condensateur d'intégration monté entre une première électrode de la paire drain-source du transistor MOS de lecture et un potentiel de référence. Le type du transistor MOS conditionne la polarité des charges que le circuit de lecture est capable de lire sans se bloquer. L'entrée du circuit se trouve au niveau de la seconde électrode de la paire drain-source du transistor MOS de lecture. Les charges injectées à l'entrée doivent traverser le transistor MOS de lecture pour être intégrées par le condensateur. Le transistor MOS de lecture est commandé par une tension de contrôle variant de manière sensiblement inversement proportionnelle par rapport à la tension à l'entrée. Le circuit comporte des moyens pour détecter, l'arrivée à l'entrée de charges de polarité opposée à celles qu'il est capable de lire et des moyens pour imposer à la tension à l'entrée, après une telle détection, une valeur d'équilibre égale ou proche d'une valeur de base qu'elle prend entre deux intégrations successives de charges de la polarité désirée, de manière à éviter un blocage prolongé du transistor MOS de lecture lors de l'arrivée de charges de polarité désirée.

Les moyens pour détecter l'arrivée de charges de polarité non désirée peuvent être réalisés par un amplificateur inverseur dont l'entrée reçoit la tension de contrôle, l'amplificateur possédant un seuil de commutation dont le franchissement par la tension de contrôle en s'éloignant d'une valeur initiale prise lorsque la tension à l'entrée a pour valeur la valeur de base, traduit la présence de charges de polarité non désirée en entrée.

Les moyens pour imposer la valeur d'équilibre peuvent comporter un transistor MOS de déblocage dont l'une des électrodes de la paire drain-source est reliée à l'entrée, dont l'autre électrode de la paire drain-source est portée à la valeur d'équilibre et qui est commandé par la sortie des moyens pour détecter l'arrivée de charges de polarité non désirée.

Pour éviter l'apparition d'oscillations parasites, le circuit de lecture peut comporter des moyens pour retarder l'imposition de la valeur d'équilibre par rapport à la détection de l'arrivée des charges de polarité non désirée.

Les moyens pour retarder l'imposition de la valeur d'équilibre peuvent être réalisés par un interrupteur retardateur qui tant qu'il est ouvert empêche l'application de la tension d'équilibre à l'entrée. Cet interrupteur retardateur est relié à l'une des électrodes de la paire drain-source du transistor MOS de déblocage.

Dans un souci de simplification et d'efficacité, la commande de l'interrupteur retardateur peut être rendue synchrone de celle d'un interrupteur de réinitialisation monté en parallèle avec le condensateur d'intégration.

Le seuil de commutation est inférieur à la valeur initiale de la tension de contrôle lorsque le circuit de lecture est prévu pour lire des électrons et supérieur à cette dernière lorsque le circuit de lecture est prévu pour lire des trous.

De la même manière la valeur d'équilibre est inférieure ou égale à la valeur de base lorsque le circuit de lecture est prévu pour lire des électrons et supérieure ou égale à cette dernière lorsque le circuit de lecture est prévu pour lire des trous

La tension de contrôle peut être délivrée par un amplificateur inverseur monté entre l'entrée et la grille du transistor MOS de lecture. Il est préférable de choisir cet amplificateur à fort gain.

D'autres caractéristiques et avantages de l'invention apparaîtront à la lecture des exemples décrits ci-dessous et illustrés par les figures jointes qui représentent :

- la figure 1 (déjà décrite) un capteur d'image à l'état solide associé à des circuits de lecture de type connu ;
- les figures 2a à 2e (déjà décrites) des chronogrammes montrant notamment l'évolution des tensions à l'entrée et à la sortie d'un des circuits de lecture de la figure 1 en fonction de l'arrivée de charges ;
- la figure 3 un capteur d'image à l'état solide associé à une première configuration de circuits de lecture selon l'invention ;
- les figures 4a à 4f des chronogrammes montrant notamment l'évolution des tensions à l'entrée et à la sortie d'un des circuits de lecture de la figure 3 en fonction de l'arrivée de charges ;
- la figure 5 un capteur d'image à l'état solide associé à une seconde configuration de circuits de lecture selon l'invention, cette seconde configuration introduisant le retardateur ;
- les figures 6a à 6f des chronogrammes montrant notamment l'évolution des tensions à l'entrée et à la sortie d'un des circuits de lecture de la figure 5 en fonction de l'arrivée de charges.

Sur ces figures les échelles ne sont pas forcément respectées dans un souci de clarté.

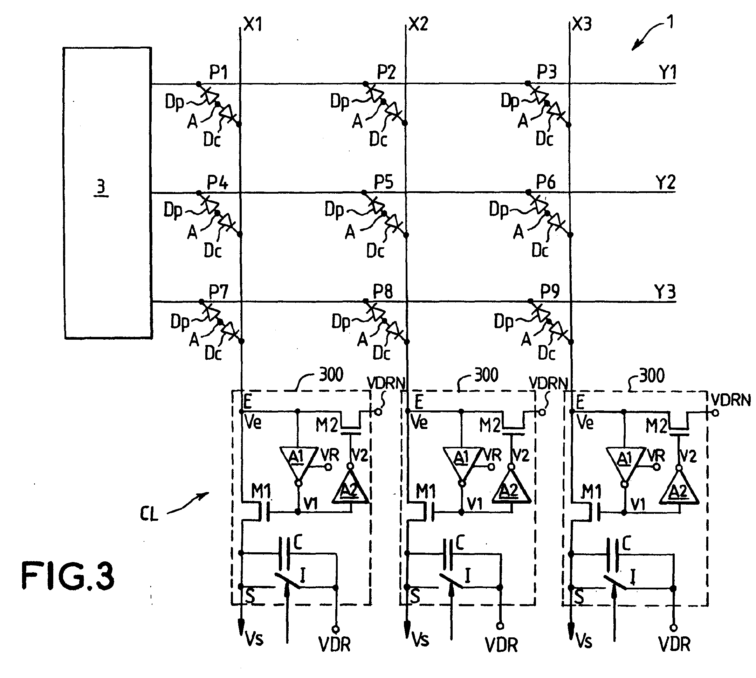

La figure 3 représente à la manière de la figure 1, un schéma montrant un capteur d'image associé à plusieurs circuits de lecture de charges 300 conformes à l'invention. Les structures du capteur d'image et du dispositif d'adressage sont identiques à celles de la figure 1. Les circuits de lecture 300 ont pour base ceux représentés à la figure 1 avec des caractéristiques additionnelles.

Chaque circuit de lecture 300 comporte des moyens pour détecter l'arrivée de charges de polarité non désirée et des moyens pour imposer à la tension d'entrée, après détection de l'arrivée de charges de polarité non désirée, une valeur d'équilibre proche ou égale à la valeur de base qu'elle prend entre deux intégrations successives de charges de polarité désirée de manière à éviter un blocage du circuit lors de l'arrivée de charges de polarité désirée.

Plus précisément les moyens pour détecter l'arrivée des charges de polarité non désirée peuvent être réalisés par un second amplificateur inverseur A2 monté en série avec l'amplificateur inverseur d'accélération A1, à sa sortie. Les moyens M2 pour imposer à l'entrée E du circuit de lecture 300 une valeur d'équilibre VDRN proche ou égale à la valeur de base Vb comportent un transistor MOS de déblocage M2 dont la grille g est commandée par la sortie du second amplificateur inverseur A2, dont l'une des électrodes de la paire d'électrodes drain-source est portée à la valeur d'équilibre VDRN et dont l'autre électrode de la paire est reliée à l'entrée E du circuit. On préférera choisir une valeur d'équilibre VDRN légèrement différente de la valeur de base Vb car on ne connaît pas avec très grande précision cette dernière et il faut tenir compte des fluctuations des valeurs électriques des composants semi-conducteurs.

En pratique, si la tension d'alimentation VR vaut -2, 75 volts et que la valeur de base Vb est de -1,2 Volts, on peut choisir une valeur d'équilibre VDRN à -1, 5 Volts ce qui donne 0, 3 Volts de marge.

Le gain du second amplificateur A2 est non critique car il n'y a pas de problème de bruit sur cet étage. Il est choisi de préférence avec une très faible consommation électrique pour ne pas rajouter de puissance dissipée inutile.

Le second amplificateur inverseur A2 possède un seuil de commutation Vc qui traduit la présence de charges de polarité non désirée en entrée E du circuit de lecture 300. Cela signifie que la tension de sortie V2 du second amplificateur inverseur A2 reste constante, à une valeur initiale V2i, tant que la tension de contrôle V1 n'a pas passé le seuil de commutation Vc depuis sa valeur initiale V1i. Dès que ce seuil Vc est passé, la tension de sortie V2 suit, avec un effet d'inversion et d'amplification, les variations de la tension de contrôle V1. Dès que la tension de contrôle V1 passe le seuil de commutation Vc vers la valeur V1 i initiale, la tension de sortie V2 reprend sa valeur initiale V2i.

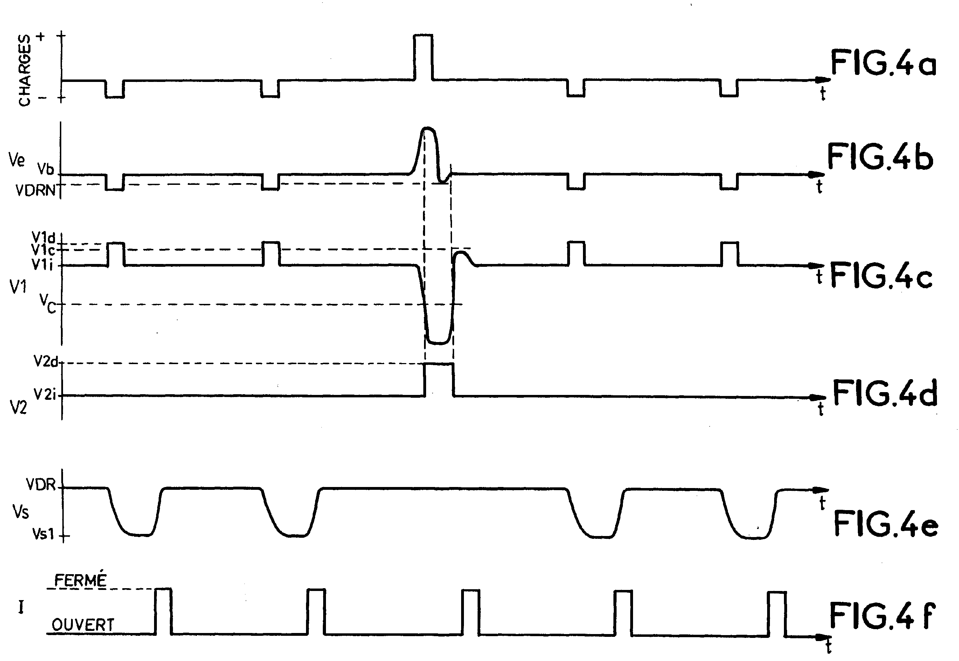

A la manière des figures 2a à 2e, les chronogrammes des figures 4a à 4f montrent les allures, respectivement, de la quantité de charges arrivant en entrée E d'un des circuits de lecture 300, de la tension Ve en entrée E du circuit, de la tension de contrôle V1 appliquée sur la grille g du transistor MOS M1, de la tension V2 en sortie du second amplificateur inverseur A2, de la tension Vs en sortie S du circuit de lecture 30 et enfin de l'état de l'interrupteur I qui réinitialise le condensateur C. On suppose qu'avant l'arrivée des premières charges, la tension d'entrée Ve est à la valeur de base Vb, la tension de contrôle V1 à une valeur initiale V1i, la tension de sortie V2 du second amplificateur inverseur A2 à une valeur initiale V2i et la tension de sortie Vs à la valeur de référence VDR.

Lorsque des charges de polarité désirée (dans l'exemple des électrons) arrivent à l'entrée E du circuit de lecture 300, la tension Ve se met à décroître depuis la valeur de base Vb.

La tension de contrôle V1 se met à croître depuis la valeur initiale V1i jusqu'à atteindre une valeur V1d telle que le transistor MOS de lecture M1 se trouve dans un état débloqué, sa tension de seuil V1c a été atteinte. Les charges peuvent être intégrées. La tension de sortie V2 du second amplificateur inverseur A2 reste constante à sa valeur initiale V2i et le transistor MOS de déblocage M2 initialement bloqué reste bloqué. La tension Vs à la sortie S du circuit initialement portée à la valeur VDR se met à décroître jusqu'à atteindre la valeur Vs1 après intégration de toutes les charges reçues. Lorsque toutes les charges sont intégrées, la tension Ve à l'entrée revient à sa valeur de base Vb, la tension V1 à la sortie revient également à sa valeur initiale V1i et le transistor MOS de lecture M1 se bloque. La tension V2 reste à sa valeur initiale V2i car le seuil de commutation Vc n'a pas été passé par la tension de contrôle V1. Le transistor MOS de déblocage M2 reste bloqué. La tension Vs conserve la valeur Vs1 atteinte tant que l'interrupteur I de réinitialisation reste en position ouverte, puis repasse à la valeur VDR de référence dès la fermeture de l'interrupteur I.

Lorsqu'un grand nombre de charges de polarité non désirée (dans l'exemple des trous) arrive en entrée E du circuit 300 de lecture, la tension Ve à l'entrée augmente fortement depuis la valeur de base Vb, la tension V1 de contrôle qui varie de manière sensiblement inversement proportionnelle par rapport à la tension Ve à l'entrée décroît brutalement depuis la valeur V1i initiale. Le transistor MOS de lecture M1 qui était initialement bloqué reste bloqué, sa tension de seuil V1c n'est pas atteinte par V1. La tension de sortie Vs reste à sa valeur de référence VDR. Dès que la tension de contrôle V1 passe le seuil Vc de commutation du second amplificateur inverseur A2, la tension de sortie V2 qui était à une valeur initiale V2i se met à croître jusqu'à atteindre une valeur V2d de déblocage du transistor MOS de déblocage M2. L'arrivée des charges de polarité non désirée a été détectée. La mise en conduction du transistor MOS de déblocage M2 a pour conséquence d'imposer à la tension d'entrée Ve la valeur d'équilibre VDRN.

La valeur d'équilibre VDRN est dans ce cas inférieure ou égale à la valeur de base Vb car les charges de polarité non désirée sont des trous et le transistor MOS de lecture M1 de type N. Si les charges de polarité non désirée avaient été des électrons et le transistor de lecture MOS M1 de type P, la valeur d'équilibre VDRN aurait été supérieure ou égale à la valeur de base Vb. La variation de la tension Ve vers la valeur VDRN entraîne une augmentation de la tension de contrôle V1 qui repasse le seuil de commutation Vc du second amplificateur inverseur A2. La tension V2 en sortie du second amplificateur inverseur A2 retourne à la tension initiale V2i et le transistor MOS de déblocage M2 se bloque. La tension d'entrée Ve reprend alors sa valeur de base Vb et la tension de contrôle V1 sa valeur initiale V1 i.

En ce qui concerne le transistor MOS de lecture M1, il reste bloqué tant que la tension de contrôle V1 n'atteint pas la tension de seuil V1 c du transistor de lecture et la tension Vs à la sortie du circuit de lecture 300 reste à sa valeur de référence VDR. Cette variante est représentée sur le chronogramme de la figure 4e.

L'information délivrée par le circuit de lecture lors de la lecture du point photosensible défectueux est perdue puisque la tension Vs à la sortie ne varie pas. Ce qui compte c'est que lorsque de nouveau des charges de polarité désirée arrivent à l'entrée E du circuit de lecture 300, celles-ci puissent être lues, ce qui est bien le cas.

Il se peut que le transistor MOS de lecture M1 se débloque si la tension de contrôle V1 remonte audelà de la tension de seuil V1c. Un courant circule alors de l'entrée E vers la capacité d'intégration et la tension Vs décroît jusqu'à la valeur Vs1. La tension Vs conserve cette valeur tant que l'interrupteur I reste en position ouverte puis ensuite reprend sa valeur VDR. Une information est délivrée par le point photosensible défectueux. Mais ce qui compte c'est que lorsque de nouveau des charges de polarité désirée arrivent à l'entrée E du circuit de lecture 300, celles ci puissent être lues, ce qui est bien le cas.

Dans l'exemple avec des charges de polarité désirée de type électrons, le seuil de commutation Vc du second amplificateur inverseur A2 est inférieur à la valeur initiale de la tension de contrôle V1. La valeur d'équilibre VDRN est inférieure ou égale de la valeur de base Vb. Si elle est inférieure elle en reste proche. Dans l'exemple VDRN vaut - 1,5 Volts au lieu de -1,2 Volts.

Avec des charges de polarité désirée de type trous, le seuil Vc aurait été supérieur à la valeur initiale V1i de la tension de contrôle V1 et la tension d'équilibre VDRN serait supérieure ou égale à Vb. Si elle est supérieure à Vb elle en reste proche. Les chronogrammes seraient inversés et leur représentation n'est pas nécessaire pour comprendre l'invention.

On peut avantageusement retarder l'application de la valeur d'équilibre VDRN par rapport à la détection de l'arrivée de charges de polarité non désirée. En séparant dans le temps la détection du défaut et sa correction, on rend la correction plus stable et donc plus efficace. On s'affranchit d'éventuelles oscillations qui peuvent apparaître et qui sont gênantes. La correction est appliquée bien sûr avant l'arrivée de nouvelles charges.

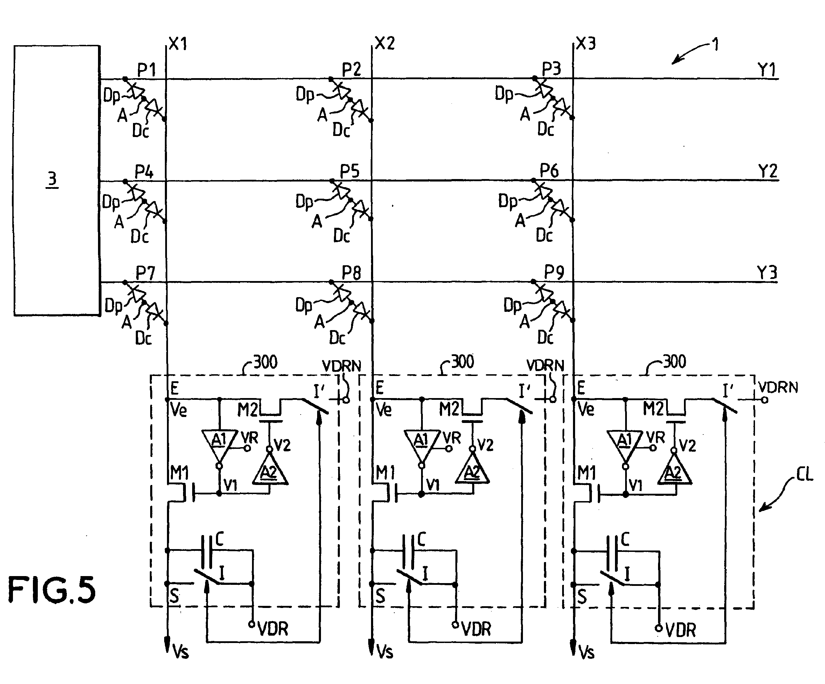

La figure 5 montre un mode de réalisation du circuit de lecture permettant un tel retardement de la correction. Des moyens pour retarder l'application de la valeur d'équilibre VDRN coopèrent avec les moyens pour imposer cette valeur d'équilibre à l'entrée E. Les moyens pour retarder l'application de la valeur d'équilibre VDRN à l'entrée du circuit de lecture sont réalisés par un interrupteur I' placé entre la source de tension délivrant la valeur VDRN et l'entrée E du circuit de lecture.

Sur le schéma il est relié d'un côté à la seconde électrode de la paire drain-source du transistor MOS de déblocage M2 et de l'autre à la source de tension délivrant la valeur d'équilibre VDRN. On aurait pu le placer entre la première électrode de la paire drain-source du transistor MOS de déblocage M2 et l'entrée E.

Cet interrupteur I' est ouvert tant que le transistor MOS de déblocage M2 est bloqué, c'est à dire quand aucun défaut n'est détecté. A l'instant t1 où un défaut est détecté, c'est à dire lorsque le seuil de commutation Vc est franchi par la tension de contrôle V1 qui s'éloigne de sa valeur initiale V1c, l'interrupteur I' conserve son état ouvert. Il ne change d'état que plus tard, à un instant t2 séparé de l'instant t1 d'un intervalle de temps δt mais avant bien sûr l'arrivée de nouvelles charges à l'entrée E.

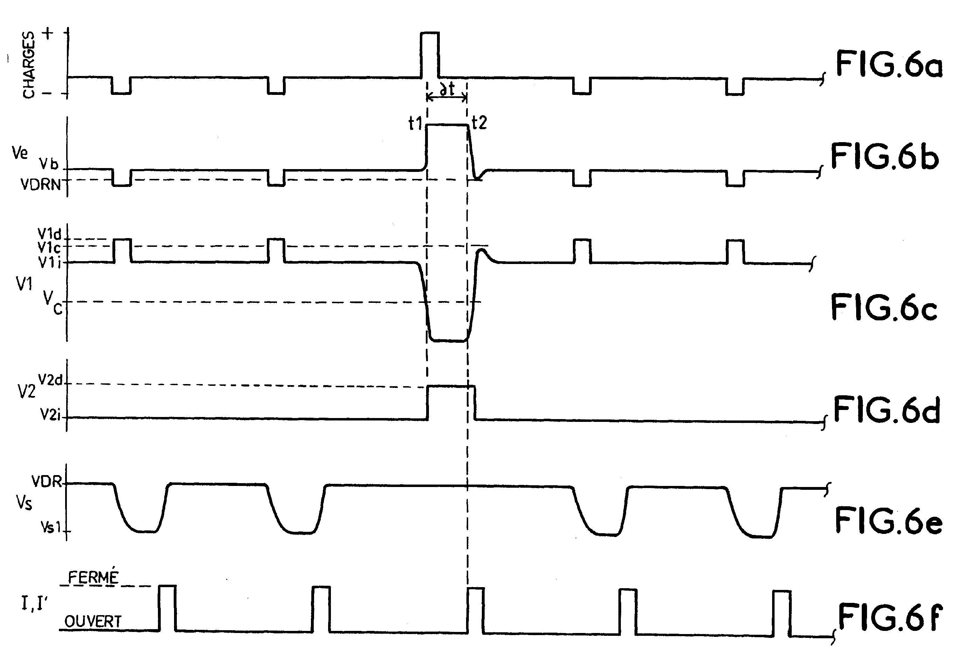

Sur les chronogrammes des figures 6, les instants t1 et t2 sont repérés. Dans l'exemple décrit l'instant t2 coïncide avec la fermeture de l'interrupteur I de réinitialisation du condensateur C.

Dans cette variante avantageuse, en présence de charges de polarité non désirée, on évite que Vs prenne la valeur Vs1. Elle est toujours bloquée à VDR car l'application de la valeur VDRN à Ve ne se fait que lorsque l'interrupteur I est fermé. Cette synchronisation a pour avantage de ne pas multiplier les circuits de commande. On évite aussi des problèmes de récupération qui peuvent perturber la lecture du point suivant.

Les interrupteurs I et I' peuvent être réalisés par des transistors MOS. Le transistor MOS de lecture M1 et celui de déblocage M2 sont de même type et fonction de la polarité des charges à lire.

**Revendications**

**1.** Circuit de lecture de charges injectées à son entrée (E) comportant un transistor MOS de lecture (M1) dont le type conditionne la polarité des charges que le circuit de lecture est capable de lire sans se bloquer, et un condensateur d'intégration (C) monté entre une première électrode de la paire drain-source du transistor MOS de lecture (M1) et un potentiel de référence (VDR), l'entrée (E) se trouvant au niveau de la seconde électrode de la paire drain-source du transistor MOS de lecture (M1), les charges injectées devant traverser le transistor MOS de lecture (M1) pour être intégrées par le condensateur (C), le transistor MOS de lecture (M1) étant commandé par une tension de contrôle variant de manière sensiblement inversement proportionnelle par rapport à la tension à l'entrée, caractérisé en ce qu'il comporte des moyens (A2) pour détecter, l'arrivée à l'entrée (E) de charges de polarité opposée à celles qu'il est capable de lire et des moyens (M2) pour imposer à la tension à l'entrée, après une telle détection, une valeur d'équilibre (VDRN) égale ou proche d'une valeur de base (Vb) qu'elle prend entre deux intégrations successives de charges de la polarité désirée, de manière à éviter un blocage prolongé du transistor MOS de lecture (M1) lors de l'arrivée de charges de polarité désirée.

**2.** Circuit de lecture de charges selon la revendication 1, caractérisé en ce que les moyens (A2) pour détecter l'arrivée de charges de polarité non désirée comportent un amplificateur inverseur dont l'entrée reçoit la tension de contrôle (V1), l'amplificateur possédant un seuil de commutation (Vc) dont le franchissement par la tension de contrôle (V1) en s'éloignant d'une valeur initiale (V1i) prise lorsque la tension à l'entrée a pour valeur la valeur de base (Vb), traduit la présence de charges de polarité non désirée en entrée.

**3.** Circuit de lecture de charges selon l'une des revendications 1 ou 2, caractérisé en ce que les moyens pour imposer la valeur d'équilibre (VDRN) comportent un transistor MOS de déblocage (M2) dont l'une des électrodes de la paire drain-source est reliée à l'entrée (E) dont l'autre électrode de la paire drain-source est portée à la valeur d'équilibre (VDRN) et qui est commandé par la sortie des moyens (A2) pour détecter l'arrivée de charges de polarité non désirée .

**4.** Circuit de lecture de charges selon l'une des revendications 1 à 3, caractérisé en ce qu'il comporte des moyens pour retarder l'imposition de la valeur d'équilibre par rapport à la détection de l'arrivée des charges de polarité non désirée.

**5.** Circuit de lecture de charges selon la revendication 4, caractérisé en ce que les moyens pour retarder l'imposition de la valeur d'équilibre comportent un interrupteur (I') retardateur qui tant qu'il est ouvert empêche l'application de la valeur d'équilibre à l'entrée.

**6.** Circuit de lecture de charges selon l'une des revendications 1 à 5, caractérisé en ce que l'interrupteur retardateur est relié à l'une des électrodes de la paire drain-source du transistor MOS de déblocage (M2).

7.  Circuit de lecture de charges selon l'une des revendications 5 ou 6, comportant en parallèle avec le condensateur (C) d'intégration un interrupteur (I) de réinitialisation, caractérisé en ce que la commande de l'interrupteur de réinitialisation (I) et celle de l'interrupteur retardateur (I') sont synchronisées.

8.  Circuit de lecture de charges selon l'une des revendications 2 à 7, caractérisé en ce que le seuil de commutation (Vc) est inférieur à la valeur initiale (V1i) lorsque le circuit de lecture est prévu pour lire des électrons.

9.  Circuit de lecture de charges selon l'une des revendications 2 à 7, caractérisé en ce que le seuil de commutation (Vc) est supérieur à la valeur initiale (V1i) lorsque le circuit de lecture est prévu pour lire des trous.

10. Circuit de lecture de charges selon l'une des revendications 1 à 9, caractérisé en ce que la valeur d'équilibre (VDRN) est inférieure ou égale à la valeur de base (Vb) lorsque le circuit de lecture est prévu pour lire des électrons

11. Circuit de lecture de charges selon l'une des revendications 1 à 9, caractérisé en ce que la valeur d'équilibre (VDRN) est supérieure ou égale à la valeur de base (Vb) lorsque le circuit de lecture est prévu pour lire des trous

12. Circuit de lecture de charges selon l'une des revendications 1 à 11, caractérisé en ce que la tension de contrôle (V1 ) est délivrée par un amplificateur inverseur (A1) monté entre l'entrée (E) et la grille du transistor MOS de lecture (M1).

# FIG.1

FIG.2a

FIG.2b

FIG.2c

FIG.2d

FIG.2e

CHARGES
+
−

Ve    Vb

V1    V1d
      V1i

VDR
Vs
Vs 1

FERMÉ
I
OUVERT

EP 1 109 171 A1

FIG.3

FIG.4a

FIG.4b

FIG.4c

FIG.4d

FIG.4e

FIG.4f

CHARGES +, −

Ve  Vb, VDRN

V1d, V1c, V1i, V1, Vc

V2d, V2i, V2

VDR, Vs, Vs1

I  FERMÉ, OUVERT

EP 1 109 171 A1

FIG.5

EP 1 109 171 A1

CHARGES +

CHARGES −

FIG.6a

Ve  Vb
VDRN

t1  ∂t  t2

FIG.6b

V1d
V1c
V1i
V1
Vc

FIG.6c

V2d
V2
V2i

FIG.6d

VDR
Vs
Vs1

FIG.6e

FERMÉ
I,I'
OUVERT

FIG.6f

EP 1 109 171 A1

EP 1 109 171 A1

| | Office européen des brevets | RAPPORT DE RECHERCHE EUROPEENNE | Numéro de la demande EP 00 40 3491 |

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | EP 0 665 685 A (SONY CORP)<br>2 août 1995 (1995-08-02)<br>* page 3, ligne 1 - page 4, ligne 37 *<br>* page 5, ligne 24 - ligne 47 *<br>* figure 3 *<br>--- | 1-12 | G11C27/02 |
| A | US 4 827 145 A (ARQUES MARC)<br>2 mai 1989 (1989-05-02)<br>* colonne 16, ligne 59 - colonne 17, ligne 67 *<br>* figures 14,15 *<br>----- | 1-12 | |

DOMAINES TECHNIQUES RECHERCHES (Int.Cl.7)

G11C

Le présent rapport a été établi pour toutes les revendications

| Lieu de la recherche | Date d'achèvement de la recherche | Examinateur |
|---|---|---|
| LA HAYE | 8 février 2001 | Colling, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.................................................................
& : membre de la même famille, document correspondant

EPO FORM 1503 03.82 (P04C02)

14

**ANNEXE AU RAPPORT DE RECHERCHE EUROPEENNE
RELATIF A LA DEMANDE DE BREVET EUROPEEN NO.**

EP 00 40 3491

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-02-2001

| Document brevet cité au rapport de recherche | | Date de publication | Membre(s) de la famille de brevet(s) | | Date de publication |
|---|---|---|---|---|---|
| EP 0665685 | A | 02-08-1995 | JP<br>US<br>US | 7255013 A<br>6037979 A<br>5808677 A | 03-10-1995<br>14-03-2000<br>15-09-1998 |
| US 4827145 | A | 02-05-1989 | FR<br>DE<br>EP<br>JP | 2593987 A<br>3765272 D<br>0237365 A<br>62202684 A | 07-08-1987<br>08-11-1990<br>16-09-1987<br>07-09-1987 |

EPO FORM P0460